# EUROPEAN PATENT APPLICATION

(11) **EP 4 752 934 A1**
(43) Date of publication of application: **03.06.2026**
(21) Application number: 24216177.6
(22) Date of filing: 28.11.2024
(51) Int. Cl.: H01L 21/683, H01L 21/268

(54) **A METHOD FOR PREPARING AN ARRAY OF INTEGRATED CIRCUIT DEVICES FOR TRANSFER PRINTING, A METHOD FOR TRANSFER PRINTING, AND AN ASSEMBLY OF INTEGRATED CIRCUIT DEVICES FOR TRANSFER PRINTING**

(71) Applicant: Imec VZW, 3001 Leuven (BE); Universiteit Gent, 9000 Gent (BE)
(72) Inventor: CHEN, Ye, 9052 Gent (BE); KANNOJIA, Harindra Kumar, 9000 Gent (BE); VAN STEENBERGE, Geert, 9040 Sint-Amandsberg (BE); ROELKENS, Gunther, 9260 Schellebelle (BE)
(74) Representative: AWA Sweden AB

(57) **Abstract**

A method (100) for preparing an array of integrated circuit devices (212) for transfer printing is provided. The method comprises: debonding (110) a first temporary bonding layer (222) arranged between a first temporary carrier layer (220) and the array of integrated circuit devices (212); and a second temporary bonding layer (232) is arranged between a second temporary carrier layer (230) and the array of integrated circuit devices (212); removing (112) the first temporary bonding layer (222) and the first temporary carrier layer (220); exposing (114) parts (234) of the second temporary bonding layer (232) to second electromagnetic radiation (252) in order to reduce a binding strength of the exposed parts (234); wherein reducing the binding strength facilitates lifting of the integrated circuit devices (212).

## Description

### Technical field

The present description relates to transfer printing. In particular, the present description relates to a method for preparing an array of integrated circuit devices for transfer printing and to an assembly of integrated circuit devices which may be used for transfer printing. In addition, the present description relates to a method for transfer printing.

### Background

Integrated photonics circuits are increasingly used. The integrated photonics circuits provide a compact arrangement of photonic components which may be advantageously used in many applications.

Integrated photonics circuits may include components, such as phase shifters, high-speed modulators, detectors, and optical sources, that may need to be electronically controlled. For instance, the components of the integrated photonics circuits may be arranged on a photonics chip, whereas electronic circuits for providing electronic control may need to be arranged on a separate chip. Thus, rapid scaling-up of integrated photonics circuits has introduced challenges in controlling and manipulating on-chip photonics components. These challenges stem from limitations posed by non-intimate integration of the electronic circuits with the photonic integrated circuits. The challenges in integration of the electronic circuits with the photonic integrated circuits may result in high power consumption and high parasitic effects.

In response to these challenges, various methods have been explored to address these issues. For instance, transfer printing solutions for integrating separately produced electronic circuits and photonic integrated circuits have been proposed. However, there is still a need for improving the integration of electronic circuits and photonic integrated circuits using transfer printing.

It should further be realized that transfer printing may be used in other applications, not necessarily related to integrating an electronic circuit with a photonic integrated circuit. Improvements in transfer printing may thus be relevant to other applications.

### Summary

It is an objective of the present description to facilitate transfer printing of integrated circuit devices. In particular, it is an object to facilitate transfer printing that does not necessarily rely on breaking of tethers or other physical components of the integrated circuit devices.

It is a further objective of the present description to enable a high-quality array of integrated circuit devices for transfer printing.

It is a further objective of the present description to facilitate easy and/or low-cost manufacturing of an array of integrated circuit devices for transfer printing.

These and other objectives of the present description are at least partly met by the invention as defined in the independent claims. Preferred embodiments are set out in the dependent claims.

In the following, relative spatial terms such as "top", "bottom", "lower", "vertical" are to be understood as denoting locations or directions within a frame of reference of the array of integrated circuit devices. In particular, the terms may be understood in relation to a normal direction to a plane spanned by the array of integrated circuit devices. Correspondingly, terms such as "lateral" and "horizontal" are to be understood as locations or directions parallel to such plane.

According to a first aspect, there is provided a method for preparing an array of integrated circuit devices for transfer printing, said method comprising:
debonding a first temporary bonding layer in order to modify material properties of a material of the first temporary bonding layer to facilitate the removal of the material of the first temporary bonding layer; wherein
   the first temporary bonding layer is arranged between a first temporary carrier layer and the array of integrated circuit devices, for binding the array of integrated circuit devices to the first temporary carrier layer, wherein the first temporary bonding layer covers at least a first side of the array of integrated circuit devices;
   a second temporary bonding layer covers at least a second side of the array of integrated circuit devices, wherein the second side is opposite to the first side; and
   the second temporary bonding layer is arranged between a second temporary carrier layer and the array of integrated circuit devices, for binding the array of integrated circuit devices to the second temporary carrier layer;
removing the first temporary bonding layer and the first temporary carrier layer;
exposing at least parts of the second temporary bonding layer to second electromagnetic radiation in order to reduce a binding strength of the exposed parts of the second temporary bonding layer with the array of integrated circuit devices;
   wherein reducing the binding strength facilitates lifting of the integrated circuit devices from the second temporary bonding layer and the second temporary carrier layer.

Debonding the first temporary bonding layer may refer to any process by which the material properties of the material of the first temporary bonding layer are modified in order to facilitate the removal of the material of the first temporary bonding layer. This may for example include exposing the material of the first temporary bonding layer to radiation or chemicals.

The first temporary carrier layer and the array of integrated circuit devices may be bonded to each other via the first temporary bonding layer. Thus, debonding of the first temporary bonding layer may imply that the bonding of the first temporary carrier layer to the array of integrated circuit devices via the first temporary bonding layer is released.

The first temporary bonding layer covering at least the first side of the array of integrated circuit devices implies that the first temporary bonding layer extends over an entire area of the first side. The array of integrated circuit devices may be arranged in a layer such that the integrated circuit devices are displaced laterally from each other within the layer. An area of the first side of the array of integrated circuit devices may refer to a combined area of geometrically common sides for all of the devices in the array of integrated circuit devices.

The first temporary bonding layer may comprise a commercially available material for temporary bonding. For example HD3008 or HD3007 supplied by HD MicroSystems^{™}, WaferBOND^{®} HT-10.11 or HT-10.12 supplied by Brewer Science Inc.,OneFilm WSS Semiconductor Temporary bonding Film series supplied by 3M^{™}, or any material that is suitable for bonding, and subsequently debonding, the first temporary carrier layer and the array of integrated circuit devices may be used.

The second temporary bonding layer covering at least the second side of the array of integrated circuit devices implies that the second temporary bonding layer extends over an entire area of the second side. An area of the second side of the array of integrated circuit devices may refer to a combined area of geometrically common sides for all of the devices in the array of integrated circuit devices.

As used herein, the electromagnetic radiation used for exposing at least parts of the second temporary bonding layer is referred to as *"second"* electromagnetic radiation. It should be realized that the electromagnetic radiation is referred to as second electromagnetic radiation to indicate that the electromagnetic radiation is used for exposing at least parts of the *"second"* temporary bonding layer. It should further be realized that the exposing of at least parts of the second temporary bonding layer to second electromagnetic radiation does not relate to or imply that the method necessarily includes a first electromagnetic radiation. As mentioned above, the first temporary bonding layer may be debonded using radiation, such as by exposing the first temporary bonding layer to *"first'* electromagnetic radiation. Similar to the use of the epithet *"second"* as described above, the epithet *"first'* is used in order to indicate that the electromagnetic radiation is used for exposing the *"first'* temporary bonding layer. Further, as mentioned above, debonding of the first temporary bonding layer does not necessarily involve any exposure to electromagnetic radiation.

Exposing at least parts of the second temporary bonding layer to second electromagnetic radiation in order to reduce the binding strength of the exposed parts of the second temporary bonding layer may imply that the exposed parts of second temporary bonding layer is at least partially ablated and removed. Thus, exposed parts of second temporary bonding layer may be at least partially detached from the array of integrated circuit devices and the second temporary carrier layer. In other words, an effective area over which the second temporary bonding layer bonds the array of integrated circuit devices with the second temporary carrier layer is reduced, such that the bonding strength of the array of integrated circuit devices with second temporary bonding layer and the second temporary carrier layer is reduced.

The degree to which the material of the exposed parts of second temporary bonding layer are ablated may depend on properties of the second electromagnetic radiation such as power, wavelength, spot size, and position of the radiation as well as material properties of the material of the second temporary bonding layer.

Alternatively, exposing at least parts of the second temporary bonding layer to second electromagnetic radiation in order to reduce the binding strength of the exposed parts of the second temporary bonding layer does not imply that material of the second temporary bonding layer is removed or completely removed from the exposed parts. A material of the second temporary bonding layer may remain between the array of integrated circuit devices and the second temporary carrier layer after exposure. It is to be understood that the binding strength of the exposed parts is reduced due to changed material properties of the material of the secondary temporary bonding layer due to exposure to the second electromagnetic radiation. The material properties being changed upon exposure to the second electromagnetic radiation may be referred to as being less adhesive.

It should be realized that the integrated circuit devices may be any devices that are manufactured to be integrated. Thus, the integrated circuit devices may form electronic integrated circuits but may not necessarily be electronic circuits. Rather, the integrated circuit devices may be photonic integrated circuits providing photonic components for propagating and/or affecting light signals.

The integrated circuit devices may be formed by semiconductor processing technology. This may be particularly useful as available manufacturing facilities may be used for manufacturing the array of integrated circuit devices. It should be further realized that electronic integrated circuits may typically be manufactured using semiconductor processing technology but also other types of integrated circuits may be manufactured using semiconductor processing technology.

It should be realized that the integrated circuit devices of the array of integrated circuit devices may be manufactured in parallel. The integrated circuit devices may be identical which may imply that the array of integrated circuit devices may be manufactured in a fast manner. However, it should be realized that each of the integrated circuit devices may be individually designed and manufactured in the array.

The array of integrated circuit devices may be formed by at least one die. The at least one die may be a plurality of dies. The plurality of dies may form an array of dies. Each die of the plurality of dies may comprise a subarray of integrated circuit devices, or each die of the plurality of dies may comprise a single integrated circuit device. Alternatively, the at least one die may be a single die comprising the array of integrated circuit devices.

In a further alternative, the array of integrated circuit devices may be formed by a plurality of wafers, wherein each wafer of the plurality of wafers comprises an array of integrated circuit devices according to any of the embodiments described herein. The plurality of wafers may for example be III-V semiconductor wafers. The plurality of wafers may be arranged on a common larger substrate, the larger substrate may for example be a silicon wafer.

In any of the above mentioned embodiments, it is to be understood that the integrated circuit devices of the array of integrated circuit devices may be arranged laterally side by side and may have a similar thickness.

The array of integrated circuit devices may be manufactured on a common substrate, such as a semiconductor substrate. This may facilitate processing of the integrated circuit devices for manufacturing of the array of integrated circuit devices. Each of the integrated circuit devices may be a separate device, comprising one or more components manufactured to provide a desired functionality of the device.

In the case of the array of integrated circuit devices being formed by a plurality of dies, the plurality of dies may be formed from a common substrate or from a plurality of substrates. This enables increased flexibility in the type of integrated circuit devices included in the array of integrated circuit devices as different dies may be preprocessed separately.

The integrated circuit devices of the array of integrated circuit devices may for example be referred to as chips, chiplets, microchips, computer chips, silicon chips. The integrated circuit devices of the array of integrated circuit devices may comprise electronic and/or photonic components. The array of integrated circuit devices may be formed from a single wafer, for example a silicon wafer. Alternatively, the array of integrated circuit devices may be formed from a plurality of wafers.

The integrated circuit devices of the array of integrated circuit devices may all be arranged on a common device plane and separate from each other within the device plane. In other words, the integrated circuit devices may be distributed horizontally along the device plane in the pattern of an array. The device plane is parallel to a plane of the temporary carrier layer and a plane of the temporary bonding layer. The integrated circuit devices may be positioned at a same height with respect to the device plane.

The term transfer printing, which may also be referred to as micro-transfer printing, is used for referring to a process of transferring devices from an initial substrate to a target substrate. Before the transfer, the devices are arranged on and coupled to the initial substrate. After the transfer, the devices are arranged on and coupled to the target substrate. For example, a device may be transferred by coupling a stamp to the device. After being coupled to the stamp, the device is decoupled from the initial substrate as the stamp lifts the device from the initial substrate. The lifting of the device will thus only work if the stamp is coupled to the device stronger than the device is coupled to the initial substrate. The device may subsequently be arranged on and coupled to the target substrate and decoupled from the stamp. For instance, the target substrate may include one or more integrated circuits such that the device being transferred to the target substrate may be coupled to the integrated circuit(s) on the target substrate. In this manner, devices may be processed separately at the initial substrate and the target substrate, and subsequently integrated on the target substrate via transfer printing of device(s) from the initial substrate to the target substrate. As an alternative, different devices may be separately processed at different initial substrates, such as a first initial substrate and a second initial substrate. Then, a device from the first initial substrate may be transferred by transfer printing from the first initial substrate to the target substrate followed by a device from the second initial substrate being transferred by transfer printing from the second initial substrate to the target substrate.

The target substrate may for example be a circuit board, a photonic integrated circuit (PIC), a flexible substrate, electronics integrated circuit, micro-electromechanical system (MEMS) devices, photonic MEMS integrated circuits.

It should further be realized that a single integrated circuit device may be transferred to a particular target substrate. Thus, the integrated circuit devices may be transferred to different target substrates. However, it should be realized that in other embodiments, a plurality of integrated circuit devices, such as a subset of or all of the integrated circuit devices in the array, may be transferred to a common target substrate.

A plurality of integrated circuit devices may be transferred at the same time from the same initial substrate to a common target substrate. In other words, a stamp may be configured to simultaneously couple to a plurality of integrated circuit devices from the array of integrated circuit devices and transfer said plurality of integrated circuit devices. Alternatively, the integrated circuit devices may be transferred one by one by transfer printing to the target substrate. Thus, a stamp may be configured to only pick up one integrated circuit device from the array of integrated circuit devices.

Preparing an array of integrated circuit devices for transfer printing is thus to be understood as enabling the devices to be coupled to the stamp and decoupled from the initial substrate. According to the method, this is achieved by reducing the binding strength of the exposed parts of the second temporary bonding layer with the array of integrated circuit devices.

The method allows using a first temporary bonding layer to provide a robust and well-defined relation between the array of integrated circuit devices and the first temporary carrier layer. This may allow processing of the array of integrated circuit devices while bonded to the first temporary carrier layer, such as allowing the integrated circuit devices which may initially be connected through a substrate to be separated.

The method further allows using the second temporary bonding layer to provide a well-defined relation between the integrated circuit devices of the array and the second temporary carrier layer, such that the positions of the integrated circuit devices may not be affected by debonding of the first temporary bonding layer. In addition, thanks to the reduction in binding strength, the method enables decoupling the array of integrated circuit devices from the second temporary bonding layer and the second temporary carrier layer using a small force. This implies that the integrated circuit devices may be steadily connected to the second temporary carrier layer while providing a simple manner of decoupling the integrated circuit devices from the second temporary carrier layer.

In the case where the second temporary bonding layer remains between the second temporary carrier layer and the array of integrated circuit devices, the second temporary bonding layer may provide a continuous surface on which the integrated circuit devices are arranged. This facilitates keeping the integrated circuit devices in a well-defined position since the parts of the second temporary bonding layer having reduced binding strength provide support to the array of integrated circuit devices even though the parts provide no or low binding strength.

Exposing at least parts of the second temporary bonding layer may imply that other parts of the second temporary bonding layer may be unexposed to the second electromagnetic radiation. Further, the exposing of at least parts of the second temporary bonding layer to second electromagnetic radiation may be performed such that there is at least one unexposed part associated with each integrated circuit device of the array. This implies that, in the at least one unexposed part, binding strength is maintained and the unexposed part may ensure that the integrated circuit device is connected to the second temporary carrier layer. However, the unexposed part(s) associated with the integrated circuit device may constitute a small fraction of an area of the second temporary bonding layer associated with the integrated circuit device. This implies that only a small force may be required for decoupling the integrated circuit device from the second temporary bonding layer and the second temporary carrier layer.

Alternatively, exposing at least parts of the second temporary bonding layer to the second electromagnetic radiation may imply exposing all parts of the second temporary bonding layer. Exposing all parts of the second temporary bonding layer may imply uniformly exposing the second temporary bonding layer to the second electromagnetic radiation.

A region of the second temporary bonding layer being associated with a single integrated circuit device may be defined as a projection of the integrated circuit device onto the second temporary bonding layer. In other words, the region of the second temporary bonding layer being associated with a single integrated circuit device may be defined as an area being in contact with a side of the integrated circuit device facing the second temporary bonding layer.

The unexposed part(s) of the second temporary bonding layer may form a small fraction of the region of the second temporary bonding layer being associated with a single integrated circuit device. For instance, the unexposed part(s) may be less than 50% of the area of the region, such as less than 20% of the area of the region, such as less than 10% of the area of the region.

Thanks to the method of the first aspect, transfer printing is enabled that do not require tethers or the like between the devices to be transferred and the initial substrate. Thus, the method facilitates tether-free transfer printing and mitigates problems relating to the use of tethers. Problems relating to the use of tethers in transfer printing are for example that the tethers break off irregularly, causing irregularities in the transfer printed devices, and that during the breaking of the tethers particles are scattered. Scattering of particles during the fabrication of photonic and electronic devices is well known to have possible detrimental effects on the functionality of said devices.

It is a further realization that the method enables transfer printing of integrated circuit devices without posing particular requirements on a substrate on which the integrated circuit devices may be formed. For instance, the array of integrated circuit devices may be formed on a bulk Si substrate, which may allow a high degree of freedom in designing an electronic circuit. It should be realized that manufacturing of integrated circuit devices on a bulk Si substrate is a well-established and cost-efficient manner of manufacturing of integrated circuit devices.

It should further be realized that conventional transfer printing often is implemented in relation to integrated circuit devices formed on a silicon on insulator (SOI) substrate. Such transfer printing may rely on removing a release layer by etching under the integrated circuit device in order to facilitate the release of the integrated circuit device.

According to the method of the first aspect, there is no need for such release layer in order to enable the decoupling of the integrated circuit devices for transfer printing. Thus, the method of the first aspect is not limited to use of a SOI substrate for forming the integrated circuit devices, thereby providing a higher degree of freedom in designing the integrated circuit devices. However, it should be realized that the method of the first aspect may still be compatible with integrated circuit devices formed on a SOI substrate.

It is a further realization that the method enables the array of integrated circuit devices to be arranged on the even and continuous surface formed by the second temporary bonding layer, as compared to transfer printing employing under-etching of the integrated circuit devices. Even and stable distribution of the array of integrated circuit devices facilitates more efficient and reliable simultaneous transfer printing of integrated circuit devices from larger arrays of integrated circuit devices as it simplifies the alignment of a stamp or mask to the integrated circuit device to be transferred.

It is a further realization that the method enables precise control of the bond strength between the array of integrated circuit devices and the second temporary bonding layer. The bond strength can be controlled by controlling parameters of the exposure to the second electromagnetic radiation, such as power, wavelength, spot size, and position of the radiation as well as material properties of the material of the second temporary bonding layer.

According to a second aspect, there is provided an assembly of integrated circuit devices for transfer printing, the assembly comprising:
a temporary carrier layer;
a temporary bonding layer arranged on one side of the temporary carrier layer;
an array of integrated circuit devices comprising a first side and a second side, wherein the array of integrated circuit devices is arranged on the temporary bonding layer with the second side facing the temporary bonding layer;
wherein parts of the temporary bonding layer has a reduced binding strength with the array of integrated circuit devices in order to facilitate lifting of the integrated circuit devices from the temporary bonding layer and the temporary carrier layer.

The reduced binding strength of the temporary bonding layer with the array of integrated circuit devices may be achieved according to the method described in conjunction with the first aspect.

The temporary carrier layer may have a carrier layer top surface and an oppositely arranged carrier layer bottom surface. The carrier layer top surface and the carrier layer bottom surface being arranged parallel to the plane of the temporary carrier layer. The temporary carrier layer may be a rigid material, for example, but not limited to, quartz, fused quartz, fused silica.

The temporary bonding layer may have a bonding layer top surface and an oppositely arranged bonding layer bottom surface. The bonding layer top surface and the bonding layer bottom surface being arranged parallel to the plane of the temporary bonding layer.

The temporary bonding layer may be arranged on top of the temporary carrier layer so that the bonding layer bottom surface abuts the carrier layer top surface. The array of integrated circuit devices may be arranged on the temporary bonding layer so that the first or the second side of the array of integrated circuit devices abuts the bonding layer top surface. Thus, the plane of the temporary carrier layer, the plane of the temporary bonding layer, and the device plane may be parallel to each other. The integrated circuit devices of the array of integrated circuit devices may be distributed horizontally on the temporary bonding layer in the pattern of an array.

An assembly of integrated circuit devices according to the second aspect may have the same advantages, or similar advantages, as the advantages described in conjunction with the first aspect.

The assembly may provide an intermediate product that may be useful in manufacturing of an end product. For instance, the assembly may be delivered as an intermediate product to a facility or product line wherein the integrated circuit devices are to be arranged on one or more target substrates for forming end products. Thus, the assembly of integrated circuit devices may even be manufactured in a separate manufacturing facility from a facility where the end product is produced.

Effects and features of this second aspect are largely analogous to those described above in connection with the first aspect. Embodiments mentioned in relation to the first aspect are largely compatible with the second aspect.

The second electromagnetic radiation may be a second laser beam. Accordingly, the second electromagnetic radiation may be coherent radiation or formed in a coherent radiation source. However, the second electromagnetic radiation is not limited to be the second laser beam or to be coherent radiation. The second electromagnetic radiation may be incoherent radiation for example from a light emitting diode (LED) or an ultraviolet (UV) lamp.

The second laser beam may be focused to a small spot size, and may have a narrow wavelength bandwidth around a second peak wavelength. The spot size may for example be from 1µm² to 1mm², more preferably from 5µm² to 500µm². The second peak wavelength may for example be from 100 to 1000 nm, preferably from 200 to 450 nm, more preferably 240 to 360 nm. For example, the second peak wavelength may be one of 248 nm, 305 nm or 355 nm.

Using a laser beam may allow accurate control over which parts of the second temporary bonding layer that are exposed to the second electromagnetic radiation. This may allow accurate control of the reduction of the binding strength of the second temporary bonding layer.

The second laser beam may be tunable for controlling for example the spot size and/or the power of the laser beam.

The second laser beam is referred to using the epithet *"second"* as it is related to the second electromagnetic radiation. The term second laser beam does not imply that the method necessarily includes a first laser beam. Corresponding interpretation applies to usage of the term *"second"* in connection to other properties of the second electromagnetic radiation.

Exposing of at least parts of the second temporary bonding layer to the second electromagnetic radiation may comprise controlling the second laser beam to expose at least parts of the second temporary bonding layer. Such controlling of the second laser beam may comprise controlling for example the spot size and/or the power of the laser beam in dependence of a position of the second laser beam.

The controlling of the second laser beam may further imply that the second laser beam is scanned in relation to the second temporary bonding layer. Thus, desired parts of the second temporary bonding layer may be exposed by the second laser beam being controlled for directing the second laser beam towards the desired parts.

It should be realized that the controlling of the second laser beam may be such that the second laser beam is only directed to the desired parts of the second temporary bonding layer. Hence, during a scanning process, the second laser beam may be moved in steps such that a gap is provided between adjacent focus spots of the second laser beam, such that some parts of the second temporary bonding layer are unexposed.

It should be further realized that the controlling of the second laser beam may be provided in combination with a mask for ensuring that some parts of the second temporary bonding layer are unexposed. In such case, the second laser beam may not need to provide a gap between adjacent focus spots during scanning but may rather even have an overlap between adjacent focus spots. In addition, it should be realized that, if a mask is used, a beam width of the second laser beam (or the second electromagnetic radiation) may be very broad to simultaneously expose an area corresponding to the entire second temporary bonding layer, wherein the parts being exposed are selected by the mask.

The second laser beam may enable accurate control over which parts of the second temporary bonding layer are exposed. The second laser beam may further enable exposing the temporary bonding layer to high amounts of power, and enable accurate control over the amount of power to which the exposed parts of the second temporary bonding are exposed. In other words, the second laser beam may enable accurate control over which parts of the second temporary bonding layer have a reduced binding strength with the array of integrated circuit devices, and an accurate control of the degree to which the binding strength is reduced.

The debonding the first temporary bonding layer may comprise exposing the first temporary bonding layer to first electromagnetic radiation.

The first electromagnetic radiation is referred to using the epithet *"first'* as it is related to the first temporary bonding layer. Corresponding interpretation applies to the usage of the term *"first'* in connection to other properties of the first electromagnetic radiation.

The first electromagnetic radiation and the second electromagnetic radiation may be formed by the same source of electromagnetic radiation. Using a single source of electromagnetic radiation facilitates using a simple equipment in the method for preparing the array of integrated circuit devices as there is no need for several sources of electromagnetic radiation. This may also imply that the method is time-efficient and cost-efficient.

However, the debonding of the first temporary bonding layer may alternatively comprise, for example, thermal release, wet chemistry release, or mechanical release. Exposing the first temporary bonding layer to first electromagnetic radiation may be advantageous due to its compatibility with scaling up the method to manufacturing of large volumes of devices.

The first electromagnetic radiation may be a first laser beam. Accordingly, the first electromagnetic radiation may be coherent radiation or formed in a coherent radiation source. However, the first electromagnetic radiation is not limited to be the first laser beam or to be coherent radiation. The first electromagnetic radiation may be incoherent radiation for example from a light emitting diode (LED) or an ultraviolet (UV) lamp.

The first laser beam may be focused to a small spot size, and may have a narrow wavelength bandwidth around a first peak wavelength. The first peak wavelength may for example be from 100 to 1000 nm, preferably from 200 to 450 nm, more preferably 240 to 360 nm. For example, the second peak wavelength may be one of 248 nm, 305 nm or 355 nm.

Using a laser beam may allow accurate control exposing of the first temporary bonding layer to the first electromagnetic radiation. This may allow accurate control of the debonding of the first temporary bonding layer.

The first laser beam may be tunable for controlling for example the spot size and the power of the laser beam.

The first laser beam is referred to using the epithet *"first"* as it is related to the first electromagnetic radiation.

The first laser beam and the second laser beam may be formed by the same source. Using a single source for both laser beams facilitates using simple equipment in the method, as well as making the method more time-efficient and cost-efficient.

The exposing of the first temporary bonding layer to the first electromagnetic radiation may comprise scanning the first temporary bonding layer with the first laser beam.

Scanning may refer to moving the first laser beam over the first temporary bonding layer in a number of consecutive steps. The scanning may involve moving the first laser beam uniformly over the first temporary bonding layer, that is with a spot of the laser beam being moved an equal distance between consecutive steps. The beam spots of consecutive steps may have a small overlap, no overlap or a small gap in-between the beam spots.

The scanning may be provided in order to at least substantially evenly expose the first temporary bonding layer to the first electromagnetic radiation. The scanning may be performed in one or two dimensions.

The power and the spot size of the first laser beam may be constant during the scanning. Thus, the exposure of the first temporary bonding layer to the first electromagnetic radiation may be controlled for example by controlling the speed of the scan and parameters of the first laser beam, such as the power and spot size.

The method may further comprise depositing a mask on the second temporary carrier layer. The deposition of the mask may be performed before the exposing of at least parts of the second temporary bonding layer to the second electromagnetic radiation. The mask may comprise a material that at least partially blocks the second electromagnetic radiation.

The mask may be deposited on the second temporary carrier layer such that the mask is arranged between the second temporary carrier layer and the source of the second electromagnetic radiation during exposing of at least parts of the second temporary bonding layer to the second electromagnetic radiation. The mask may be arranged on the second temporary carrier layer such that the mask abuts the carrier layer bottom surface or the carrier layer top surface. The mask may be covered by the second temporary bonding layer.

Alternatively, the second temporary carrier layer may comprise a pre-fabricated mask. The pre-fabricated mask may comprise a material that at least partially blocks the second electromagnetic radiation.

The second temporary carrier layer may comprise the pre-fabricated mask. The pre-fabricated mask may be deposited on the second temporary carrier layer such that the pre-fabricated mask is arranged between the second temporary bonding layer and the source of the second electromagnetic radiation during exposing of at least parts of the second temporary bonding layer to the second electromagnetic radiation. The pre-fabricated mask may be arranged on the second temporary carrier layer such that the pre-fabricated mask abuts the carrier layer bottom surface or the carrier layer top surface. The pre-fabricated mask may be covered by the second temporary bonding layer.

The pre-fabricated mask may be reusable. In the case the second temporary carrier layer comprises a pre-fabricated mask, the method may further comprise a step of aligning the array of integrated circuit devices to the pre-fabricated mask.

The pre-fabricated mask may be formed before the array of integrated circuit devices are bonded to the second temporary carrier layer. This implies that the second temporary carrier layer may be provided with a pre-fabricated mask in a separate process for preparing the second temporary carrier layer.

An advantage of the pre-fabricated mask is that equipment for depositing a mask is not required, as compared to embodiments of the method where a mask is deposited. A reusable pre-fabricated mask further reduces the material required by the method. As a result, the pre-fabricated mask may improve for example the efficiency in fabrication, cost-efficiency and accuracy of the method.

The material that at least partially blocks the second electromagnetic radiation may be patterned in the mask or the pre-fabricated mask in order to control which parts of the second temporary bonding layer that are exposed. When the mask or the pre-fabricated mask is exposed to second electromagnetic radiation, the portion of the second electromagnetic radiation that is transmitted through the mask or the pre-fabricated mask is at least partially reduced in regions of the mask or the pre-fabricated mask that are patterned with the material that at least partially blocks the second electromagnetic radiation. The mask or the pre-fabricated mask may also be referred to as a photomask or a reticle. The mask or the pre-fabricated mask may be a hard mask. The mask or the pre-fabricated mask may comprise for example chromium, titanium, gold, or any composition of said materials.

Thus, the mask or the pre-fabricated mask facilitates improved control over which parts of the second temporary bonding layer are exposed during the exposing of at least parts of the second temporary bonding layer to the second electromagnetic radiation and which parts are unexposed. The mask or the pre-fabricated mask may enable a higher degree of control over which parts of the second temporary bonding layer are exposed than what may be possible solely by controlling the second electromagnetic radiation. The use of a mask or a pre-fabricated mask may also allow more lenient requirements of controlling the second electromagnetic radiation.

The mask or the pre-fabricated mask may for example be configured to resolve features on the order of 10 µm, preferably 1 µm, more preferably 100 nm. In some cases, the mask or the pre-fabricated mask may provide a resolution for forming patterns that even have a higher resolution than a resolution that may be provided by the second laser beam.

The first temporary carrier layer may be transparent to the first electromagnetic radiation. Thus, first electromagnetic radiation may be transmitted through the first temporary carrier layer before exposing the first temporary bonding layer.

Also or alternatively, the second temporary carrier layer may be transparent to the second electromagnetic radiation. Thus, second electromagnetic radiation may be transmitted through the second temporary carrier layer before exposing the second temporary bonding layer.

This may allow for simple exposure of the first temporary bonding layer to the first electromagnetic radiation and the second temporary bonding layer to the second electromagnetic radiation, respectively.

The second temporary bonding layer may comprise divinylsiloxane-bis-benzocyclobutene, DVS-BCB. Also or alternatively, the second temporary bonding layer may comprise for example polyimide.

These materials may be suitable for use with the exposing of at least parts of the second temporary bonding layer for reducing the binding strength of the exposed parts.

The method may further comprise selectively removing material from a first side of at least one device substrate. The at least one device substrate may comprise the array of integrated devices. The first side of the at least one device substrate may face the same direction as the first side of the array of integrated circuit devices. The selectively removing of material may form a plurality of channel portions in the at least one device substrate. Each integrated circuit device of the array of integrated circuit devices may be individually surrounded by one or more channel portions.

The at least one device substrate may be at least one wafer, for example a silicon wafer, for instance a bulk silicon wafer. Alternatively, the at least one device substrate may be one of the at least one die. The at least one die may be for example a silicon die. In other words, the at least one device substrate may be one or a plurality of wafers, or one or a plurality of dies.

Selectively removing material from the first side of the at least one device substrate may comprise etching or deep etching. Etching or deep etching may comprise plasma etching. Plasma etching may comprise for example Fluoroform, CHF₃, Carbon tetrafluoride, CF₄, Hydrogen, H₂, Argon, Ar, or Sulfur hexafluoride, SF₆ plasma etching. Prior to etching, an etch mask may be deposited on the first side of the at least one device substrate. The etch mask may be deposited for example by spin-coating or spray-coating. The etch mask may comprise a photoresist. The etching of the at least one device substrate may be done from the first side of the at least one device substrate and into the at least one device substrate, in a direction at least partially perpendicular to the first side of the at least one device substrate, for a channel depth. The channel depth may be at least 1 µm, preferably at least 5 µm, more preferably at least 25 µm. A bottom of the one or more channel portions may be defined as the surface of the channel portion farthest away from the first side of the at least one device substrate. For instance, the bottom of the channel portions may have a normal with a major direction in the same direction as the direction of a normal of the first side of the at least one device substrate. The bottom of the one or more channel portions is separated from the first side of the at least one device substrate by the etched channel depth.

Thus, the selectively removing material from the first side of the at least one device substrate defines the size and shape in the device plane of each respective integrated circuit device. It should be realized that separate channel portions may be provided for individually defining each of the integrated circuit devices. However, according to an alternative, a channel portion may define a boundary between two adjacent integrated circuit devices and the channel portions may thus be shared for defining the integrated circuit devices of the array. For instance, the channel portions may define a pattern of lines extending along a direction parallel with the first side of the at least one device substrate. The pattern may be formed by two sets of parallel lines, wherein the lines of different sets are perpendicular to each other. This implies that the channel portions may be configured to surround rectangular-shaped integrated circuit devices. However, it should be realized that the channel portions may have any layout for forming an arbitrary shape of the integrated circuit devices.

The method may further comprise bonding the device substrate comprising the array of integrated circuit devices to the first temporary bonding layer and the first temporary carrier layer. The first side of the device substrate may face the first temporary bonding layer and the first temporary carrier layer. Thus, the device substrate may be flipped before bonding the device substrate to the first temporary carrier layer.

The array of integrated circuit devices may be bonded to the first temporary bonding layer, and the first temporary bonding layer may be bonded to both the array of integrated circuit devices and the first temporary carrier layer. In other words, the first temporary bonding layer is arranged between the first temporary carrier layer and the array of integrated circuit devices and binds them together.

Bonding the device substrate comprising the array of integrated circuit devices to the first temporary bonding layer and the first temporary carrier layer may comprise depositing the first temporary bonding layer for example by spin-coating or spray-coating on the first temporary carrier layer, or on the device substrate, or on both. Bonding may comprise any combination of baking, heating up, and applying pressure to any combination of the device substrate, the first temporary carrier layer, and the first temporary bonding layer. Further, bonding may comprise curing the first temporary bonding layer, for example a nitrogen gas environment.

As described above, the plurality of channel portions may define a shape of the integrated circuit devices. However, the channel portions may not be formed through an entire thickness of the device substrate. Thus, the integrated circuit devices of the array are still physically connected to the same device substrate, when bonding the device substrate to the first temporary bonding layer and the first temporary carrier layer.

Thanks to the bonding of the device substrate to the first temporary carrier layer, the method allows the device substrate to be further processed while a relation between different integrated circuit devices in the array is maintained by the first temporary carrier layer.

In some embodiments, the method may comprise, prior to bonding the at least one device substrate comprising the array of integrated circuit devices to the first temporary bonding layer and the first temporary carrier layer, bonding the at least one device substrate to a preliminary bonding layer and a preliminary carrier layer. A second side of the at least one device substrate may face the preliminary bonding layer and the preliminary carrier layer.

It is to be understood that in embodiments where the at least one device substrate comprises a plurality of device substrates, said plurality of device substrates are bonded laterally side-by-side on the preliminary bonding layer.

The at least one device substrate comprising the array of integrated circuit devices may be bonded to the preliminary bonding layer, and the preliminary bonding layer may be bonded to both the at least one device substrate and the preliminary carrier layer. In other words, the preliminary bonding layer may be arranged between the preliminary carrier layer and the at least one device substrate and bind them together.

The preliminary bonding layer may comprise divinylsiloxane-bis-benzocyclobutene, DVS-BCB. Also or alternatively, the preliminary bonding layer may comprise for example polyimide.

Once the at least one device substrate comprising the array of integrated circuit devices have been bonded to the first temporary bonding layer and the first temporary carrier layer, the method may comprise debonding the preliminary bonding layer by modifying material properties of a material of the preliminary bonding layer to facilitate the removal of the material of the preliminary bonding layer. The method may further comprise removing the preliminary bonding layer and the preliminary carrier layer.

Debonding the preliminary bonding layer may refer to any process by which the material properties of the material of the preliminary bonding layer are modified in order to facilitate the removal of the material of the preliminary bonding layer. This may for example include exposing the material of the preliminary bonding layer to radiation or chemicals. Debonding the preliminary bonding layer may comprise exposing the preliminary temporary bonding layer to preliminary electromagnetic radiation. Preliminary electromagnetic radiation may be the same form of radiation as the second electromagnetic radiation and may originate from the same source of electromagnetic radiation as either or both of the first and the second electromagnetic radiation.

In embodiments comprising removing material from the first side of the at least one device substrate, the bonding the at least one device substrate to the preliminary bonding layer and the preliminary carrier layer is done prior to the removing of material from the first side of the at least one device substrate.

In some embodiments, one or more support structures may be bonded to the preliminary bonding layer and the preliminary carrier layer. The one or more support structures may be arranged laterally to the at least one device substrate comprising the array of integrated circuit devices. The support structures may have a similar thickness as the at least one device substrate.

In embodiments where the at least one device substrate comprises a plurality of device substrates, at least one of the one or more support structures may be arranged between each device substrate.

The at least one device substrate comprising the array of integrated circuit devices, and the one or more support structures, may be bonded, laterally side-by-side, to the preliminary bonding layer. In other words, the preliminary bonding layer may be arranged between the preliminary carrier layer and the support structures and binds them together.

The bonding of the support structures to the preliminary bonding layer and the preliminary carrier layer may provide increased stability during the bonding of the at least one device substrate to the first temporary bonding layer and the first temporary carrier layer. In particular, the support structures may provide increased stability and rigidity. The bonding of the at least one device substrates to the first temporary bonding layer and the first temporary carrier may thus be done during more straining conditions than the bonding of the device substrates and the support structures to the preliminary bonding layer and the preliminary carrier layer. More straining conditions may refer to for example higher temperature and pressure.

The method may further comprise thinning the at least one device substrate by removing material of the at least one device substrate from the second side of the at least one device substrate, the second side of the at least one device substrate being opposite to the first side of the wafer. The thinning may be performed at least until reaching a bottom of the plurality of channel portions surrounding each integrated circuit device.

Thus, after thinning the at least one device substrate, the plurality of channel portions extends entirely through the at least one device substrate in a direction at least partially perpendicular to the first side of the at least one device substrate. In other words, the integrated circuit devices of the array of integrated circuit devices are no longer physically connected to each other via the at least one device substrate. The material of the at least one device substrate between each integrated circuit device is thus removed by the combination of selectively removing material from the first side of the at least one device substrate and thinning at the second side of the at least one device substrate.

The thinning of the at least one device substrate may for example comprise chemical-mechanical polishing (CMP), and/or inductively coupled plasma (ICP).

Thanks to the array of integrated circuit devices being bonded to the first temporary carrier layer, the integrated circuit devices may be separated from each other while maintaining a relative position between different integrated circuit devices.

In embodiments comprising the bonding of the at least one device substrate to the preliminary bonding layer and the preliminary carrier layer, the thinning of the at least one device substrate is performed subsequent to the debonding of the preliminary bonding layer and the removing of the preliminary bonding layer and the preliminary carrier layer.

The method may further comprise bonding the array of integrated circuit devices to the second temporary bonding layer and the second temporary carrier layer. The second side of the array of integrated circuit devices may face the second temporary bonding layer and the second temporary carrier layer.

Thus, an assembly of the first temporary carrier layer carrying the array of integrated circuit devices may be flipped before bonding the assembly to the second temporary carrier layer. The array of integrated circuit devices may be bonded to the second temporary bonding layer, and the second temporary bonding layer may be bonded to both the array of integrated circuit devices and the second temporary carrier layer. In other words, the second temporary bonding layer is arranged between the second temporary carrier layer and the array of integrated circuit devices and binds them together. Bonding the array of integrated circuit devices to the second temporary bonding layer and the second temporary carrier layer may comprise depositing the second temporary bonding layer for example by spin-coating or spray-coating on the second temporary carrier layer, or on the array of integrated circuit devices, or on both. Bonding may comprise any combination of baking, heating up, and applying pressure to any combination of the array of integrated circuit devices, the second temporary carrier layer, and the second temporary bonding layer.

Thus, the method provides a bonding of the array of integrated circuit devices to the second temporary bonding layer and the second temporary carrier layer. After this, the relation between the integrated circuit devices may be maintained by the second temporary carrier layer. This allows the first temporary carrier layer to be removed leaving only the array of integrated circuit devices bonded to the second temporary bonding layer and the second temporary carrier layer. Thereafter, at least parts of the second temporary bonding layer may be exposed to the second electromagnetic radiation for facilitating decoupling of the integrated circuit devices from the second temporary carrier layer using a small force.

According to a third aspect, there is provided a method for transfer printing. The method for transfer printing comprises the method for preparing the array of integrated circuit devices for transfer printing according to any embodiment of the first aspect. The method for transfer printing further comprises transferring at least one integrated circuit device from the array of integrated circuit devices to a target substrate. Transferring the at least one integrated circuit device may comprise lifting the at least one integrated circuit device from the second temporary bonding layer and the second temporary carrier layer and depositing it on the target substrate.

The method for transfer printing according to the third aspect may have the same advantages, or similar advantages, as the advantages described in conjunction with the first aspect.

Effects and features of this second aspect are largely analogous to those described above in connection with the first aspect. Embodiments mentioned in relation to the first aspect are largely compatible with the second aspect.

Thanks to the integrated circuit devices being attached to the second temporary carrier layer by a reduced binding strength of the second temporary bonding layer, the lifting of the at least one integrated circuit device from the second temporary bonding layer and the second temporary carrier layer may be simplified. The force required to lift the at least one integrated circuit device from the second temporary bonding layer and the second temporary carrier layer need only overcome the binding strength of the second temporary bonding layer, which may only be present in a fraction of an area of the second temporary bonding layer.

The lifting of the integrated circuit device from the second temporary bonding layer and the second temporary carrier layer need not involve breaking of any mechanical structure.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is a flow chart of a method according to an embodiment.
Fig. 2a is a schematic top view of a device substrate comprising an array of integrated circuit devices according to an embodiment.
Figs 2b-h are schematic cross sections during steps for manufacturing of an assembly comprising an array of integrated circuit devices according to an embodiment.
Fig. 3 is a schematic cross section of a particular embodiment for a step of manufacturing the assembly comprising an array of integrated circuit devices according to an embodiment.
Fig. 4 is a schematic cross section of an assembly comprising an array of integrated circuit devices according to an embodiment.
Fig. 5 is a schematic cross section of a particular embodiment for a step of manufacturing the assembly comprising an array of integrated circuit devices according to an embodiment.
Fig. 6 is a flow chart of a method according to an embodiment.
Figs 7a-e are schematic cross sections illustrating transfer printing from an assembly comprising an array of integrated circuit devices according to an embodiment.
Fig. 8 is a schematic cross section of an assembly comprising an array of integrated circuit devices according to an embodiment.

### Detailed description

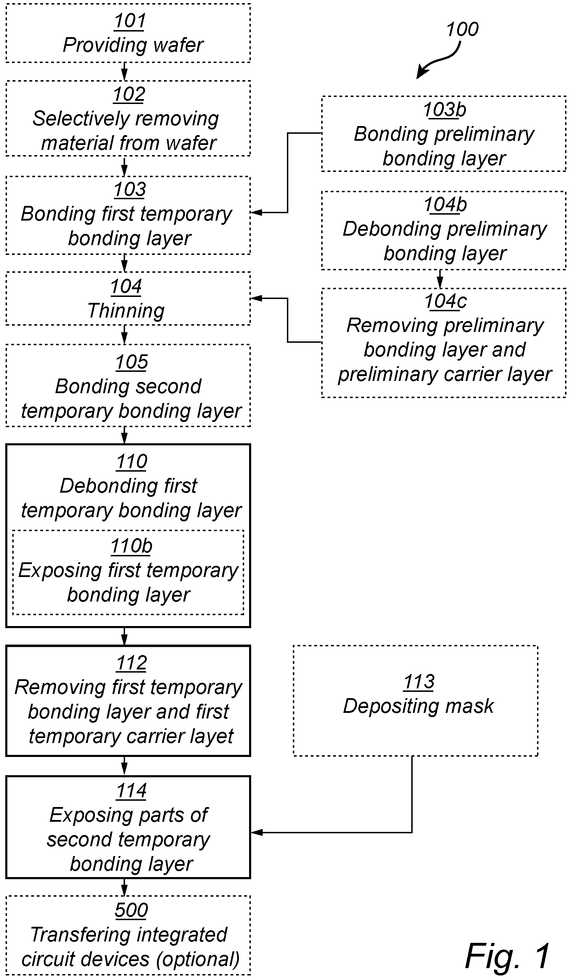

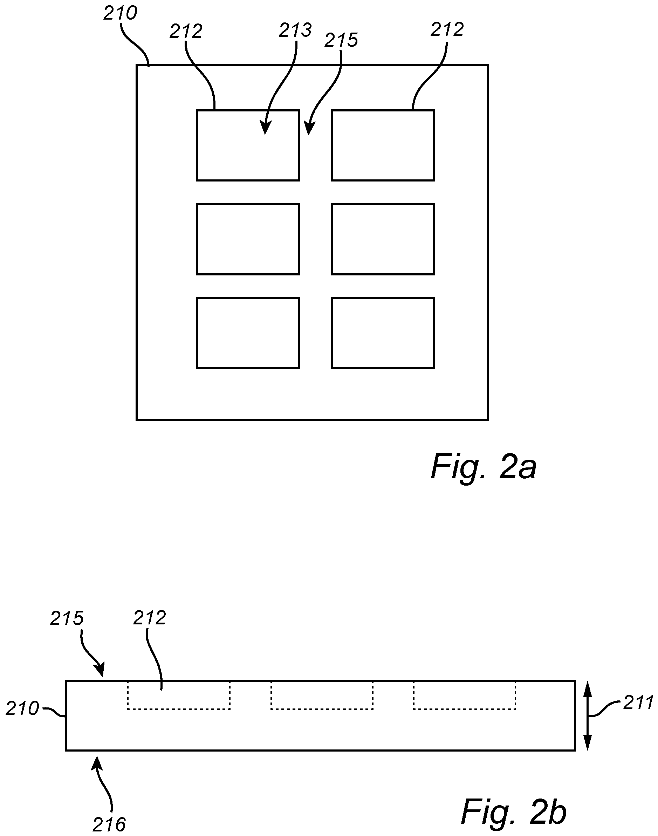

Referring to Fig. 1 in conjunction with Figs 2a-2h, a method 100 for preparing an array of integrated circuit devices 212 for transfer printing will be described. The method 100 will be described as comprising a number of steps. However, it should be realized that some of these steps are optional and may not necessarily be performed or may be performed in various different ways. Thus, the detailed description of the method provided herein should not be construed as limiting the scope of the description.

Referring to Figs 2a and 2b, the method may in an initial optional step comprise providing 101 at least one device substrate 210 comprising an array of integrated circuit devices 212. The providing 101 of the at least one device substrate 210 may refer to obtaining the at least one device substrate 210 comprising the array of integrated circuit devices 212 or may refer to performing any number of processing steps required to produce the at least one device substrate 210 comprising the array of integrated circuit devices 212.

The at least one device substrate may for example be at least one wafer or at least one die.

The array of integrated circuit devices may be formed by at least one die. The at least one die may be a plurality of dies. The plurality of dies may form an array of dies. Each die of the plurality of dies may comprise a subset array of integrated circuit devices, or each die of the plurality of dies may comprise a single integrated circuit device. Alternatively, the at least one die may be a single die comprising the array of integrated circuit devices. In a further alternative, the array of integrated circuit devices may be formed by a plurality of wafers, wherein each wafer of the plurality of wafers comprises an array of integrated circuit devices according to any of the embodiments described herein.

In any of the above mentioned embodiments, it is to be understood that the integrated circuit devices of the array of integrated circuit devices may be arranged laterally side by side and may have a similar thickness.

Each of the integrated circuit devices 212 may be a separate device, comprising one or more components manufactured to provide a desired functionality of the device. The integrated circuit devices 212 of the array of integrated circuit devices 212 may for example be referred to as chips, chiplets, microchips, computer chips, silicon chips. The integrated circuit devices 212 of the array of integrated circuit devices 212 may comprise electronic and/or photonic components.

The array of integrated circuit devices 212 may be formed on or as part of the at least one device substrate 210. The at least one device substrate 210 may be made of a semiconductor. The material of the at least one device substrate 210 may comprise for example, but not limited to, any combination of silicon, silicon on insulator, indium phosphide, gallium arsenide, gallium nitride, silicon carbide, lithium niobate, nithium tantalate, or sapphire.

The integrated circuit devices 212 may be formed in parallel in forming of the array of integrated circuit devices 212 on the at least one device substrate 210. The integrated circuit devices 212 may be formed in separate regions on the at least one device substrate 210 with the integrated circuit devices 212 being connected by material of the at least one device substrate 210 in between respective regions of the integrated circuit devices 212.

The at least one device substrate 210 comprises a first side 215 and an oppositely arranged second side 216. The first side 215 of the at least one device substrate 210 faces the same direction as a first side 213 of the array of integrated circuit devices 212.

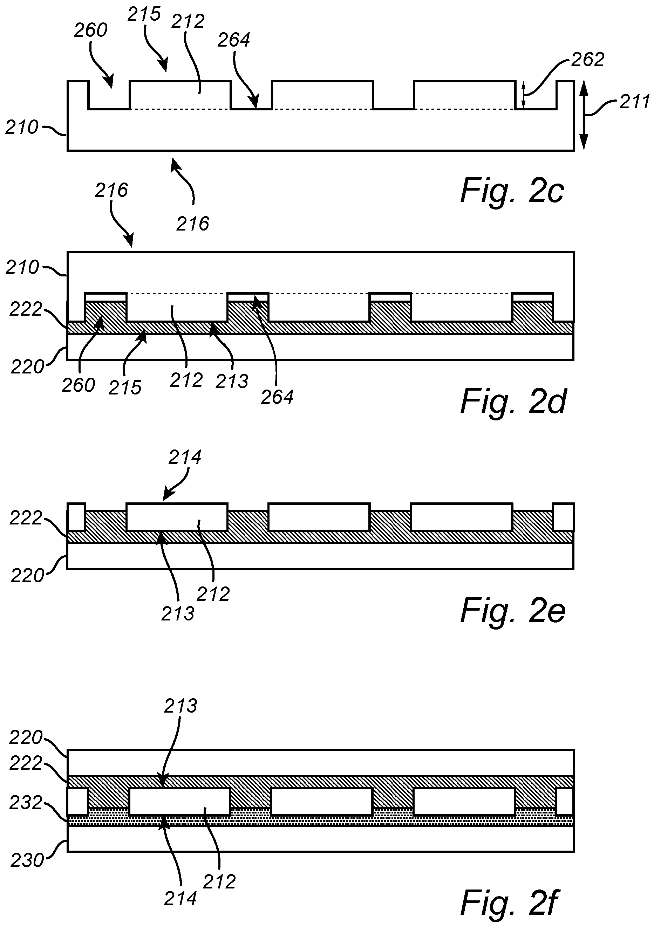

Referring to Fig. 2c, the method may in an additional optional step comprise selectively removing 102 material from the first side 215 of the at least one device substrate 210 comprising the array of integrated circuit devices 212. By selectively removing 102 material, a plurality of channel portions 260 are formed, wherein each integrated circuit device 212 of the array of integrated circuit devices 212 is individually surrounded by one or more channel portions 260.

The selectively removing 102 material may be done from the first side 215 of the at least one device substrate 210 and into the at least one device substrate 210, in a direction at least partially perpendicular to the first side 215 of the at least one device substrate 210, for a channel depth 262. The channel depth 262 may be smaller than a thickness 211 of the at least one device substrate 210. In other words, the one or more channel portions 260 may not extend to the second side 216 of the at least one device substrate 210. The channel depth 262 may be at least 1µm, preferably at least 10µm, more preferably at least 25 µm.

Selectively removing 102 material from the first side 215 of the at least one device substrate 210 may comprise etching or deep etching.

A bottom 264 of the one or more channel portions 260 may be defined as the surface of the channel portion 260 farthest away from the first side 215 of the at least one device substrate 210. For instance, the bottom 264 of the one or more channel portions 260 may have a normal with a major direction in the same direction as the direction of a normal of the first side 215 of the at least one device substrate 210. The bottom 264 of the one or more channel portions 260 is separated from the first side 215 of the at least one device substrate 210 by the etched channel depth 262.

Referring to Fig. 2d, the method may in an additional optional step comprise bonding 103 the at least one device substrate 210 comprising the array of integrated circuit devices 212 to a first temporary bonding layer 222 and a first temporary carrier layer 220. The first side 215 of the at least one device substrate 210 may face the first temporary bonding layer 222 and the first temporary carrier layer 220.

When the array of integrated circuit devices 212 is bonded to the first temporary bonding layer 222 and the first temporary carrier layer 220, the first temporary bonding layer 222 is arranged between the first temporary carrier layer 220 and the array of integrated circuit devices 212. In other words, the first temporary bonding layer 222 binds the array of integrated circuit devices 212 to the first temporary carrier layer 220. The first temporary bonding layer 222 covers at least the first side 213 of the array of integrated circuit devices 212.

The first temporary bonding layer 222 covering at least the first side 213 of the array of integrated circuit devices 212 implies that the first temporary bonding layer 222 extends over an entire area of the first side 213. The array of integrated circuit devices 212 may be arranged in a layer such that the integrated circuit devices 212 are displaced laterally from each other within the layer. An area of the first side 213 of the array of integrated circuit devices 212 may refer to a combined area of geometrically common sides for all of the devices 212 in the array of integrated circuit devices 212.

Bonding 103 the at least one device substrate 210 comprising the array of integrated circuit devices 212 to the first temporary bonding layer 222 and the first temporary carrier layer 220 may comprise flipping the at least one device substrate 210 comprising the array of integrated circuit devices 212 such that the first side 213 of the array of integrated circuit devices 212 faces the first temporary bonding layer 222 and the first temporary carrier layer 220. Flipping the at least one device substrate 210 comprising the array of integrated circuit devices 212 may also serve to expose the second side 216 of the at least one device substrate 210 for further processing steps.

As shown in Fig. 2d, the first temporary bonding layer 222 may be arranged after the bonding 103 to extend at least partly into the channel portions 260 between the integrated circuit devices 212. This may further serve to ensure a stable bonding between the array of integrated circuit devices 212 and the first temporary carrier layer 220.

Referring to Fig. 2e, the method may in an additional optional step comprise thinning 104 the at least one device substrate 210 by removing material of the at least one device substrate 210 from the second side 216 of the at least one device substrate 210. The thinning 104 may be performed at least until reaching the bottom 264 of the plurality of channel portions 260 surrounding each integrated circuit device 212.

Thinning 104 may comprise for example chemical mechanical (CMP) polishing, inductively coupled plasma (ICP) etching.

Thus, after thinning 104 the at least one device substrate 210, the plurality of channel portions 260 extends entirely through the at least one device substrate 210 in a direction at least partially perpendicular to the first side 215 of the at least one device substrate 210. In other words, the integrated circuit devices 212 of the array of integrated circuit devices 212 are no longer physically connected to each other via the at least one device substrate 210. The thinning 104 reveals a second side 214 of the integrated circuit devices 212 of the array of integrated circuit devices 212 arranged oppositely to the first side 213 of the array of integrated circuit devices 212.

The at least one device substrate 210 material between each integrated circuit device 212 is thus removed by the combination of selectively removing 102 material from the first side 215 of the at least one device substrate 210 and thinning 104 from the second side 216 of the at least one device substrate 210. Thanks to the array of integrated circuit devices 212 being bonded to the first temporary carrier layer 220, the integrated circuit devices 212 may be separated from each other while maintaining a relative position between different integrated circuit devices 212.

Referring to Fig. 2f, the method may in an additional optional step comprise bonding 105 the array of integrated circuit devices 212 to a second temporary bonding layer 232 and a second temporary carrier layer 230. The second side 214 of the array of integrated circuit devices 212 may face the second temporary bonding layer 232 and the second temporary carrier layer 230.

The second temporary bonding layer may have a thickness of at least 10 nm, preferably at least 50 nm, more preferably at least 100 nm.

When the array of integrated circuit devices 212 is bonded to the second temporary bonding layer 232 and the second temporary carrier layer 230, the second temporary bonding layer 232 is arranged between the second temporary carrier layer 230 and the array of integrated circuit devices 212. In other words, the second temporary bonding layer 232 binds the array of integrated circuit devices 212 to the second temporary carrier layer 230. The second temporary bonding layer 232 covers at least the second side 214 of the array of integrated circuit devices 212.

The second temporary bonding layer 232 covering at least the second side 214 of the array of integrated circuit devices 212 implies that the second temporary bonding layer 232 extends over an entire area of the second side 214. An area of the second side 214 of the array of integrated circuit devices 212 may refer to a combined area of geometrically common sides for all of the devices 212 in the array of integrated circuit devices 212.

Bonding 105 the at least one device substrate 210 comprising the array of integrated circuit devices 212 to the second temporary bonding layer 232 and the second temporary carrier layer 230 may comprise flipping the first temporary carrier layer 220 carrying the array of integrated circuit devices 212 such that the second side 214 of the array of integrated circuit devices 212 faces the second temporary bonding layer 232 and the second temporary carrier layer 230.

After bonding 105 the at least one device substrate 210 comprising the array of integrated circuit devices 212 to the second temporary bonding layer 232 and the second temporary carrier layer 230, the relation between the integrated circuit devices 212 may be maintained by the second temporary carrier layer 230. This allows for example the first temporary carrier layer 220 to be removed leaving only the array of integrated circuit devices 212 bonded to the second temporary bonding layer 232 and the second temporary carrier layer 230.

The method as described above presents a manner of achieving an array of integrated circuit devices 212 bonded to the second temporary bonding layer 232 and the second temporary carrier layer 230. This is a suitable starting point for further preparing the array of integrated circuit devices 212 for transfer printing. Thus, it should be understood that the above-described steps indicate some manners of achieving the starting point but other manners may also be used.

The method as described in further detail below may in following steps comprise debonding 110 the first temporary bonding layer 222, removing 112 the first temporary bonding layer 222 and the first temporary carrier layer 220, and exposing 114 at least parts 234 of the second temporary bonding layer 232. The method 100 may in this manner according to embodiments of the present description prepare an array of integrated circuit devices 212 for transfer printing.

The method thus comprises debonding 110 the first temporary bonding layer 222. Debonding 110 comprises modifying material properties of a material of the first temporary bonding layer 222 to facilitate the removal of the material of the first temporary bonding layer 222. In other words, debonding 110 the first temporary bonding layer 222 may imply that the bonding 103 of the first temporary carrier layer 220 to the array of integrated circuit devices 212 via the first temporary bonding layer 222 is released.

According to an embodiment, as further described below, the debonding 110 may involve exposing 110b the first temporary bonding layer 222 to the first electromagnetic radiation.

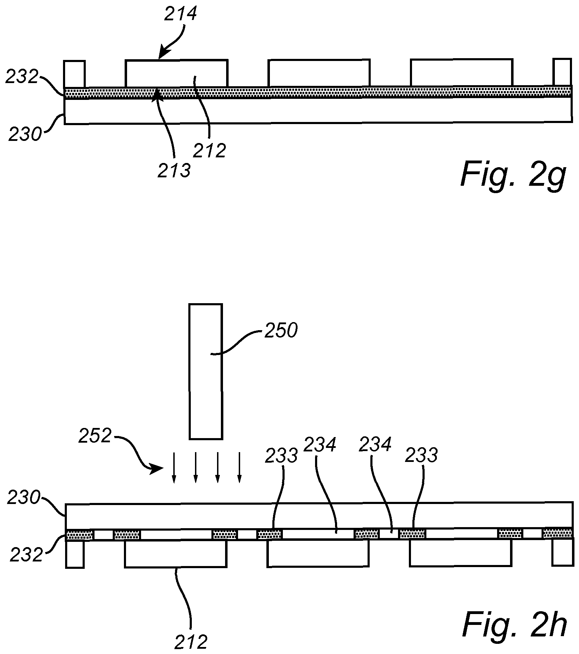

Referring to Fig. 2g, the method further comprises removing 112 the first temporary bonding layer 222 and the first temporary carrier layer 220. Thus, after the removing 112, an assembly is provided comprising the array of integrated circuit devices 212 bonded to the second temporary bonding layer 232 and the second temporary carrier layer 230.

Removing 112 the first temporary bonding layer 222 may comprise cleaning of residue of the first temporary bonding layer 222 for example by plasma cleaning, to thereby remove any residue of the first temporary bonding layer 222 from the assembly of the array of integrated circuit devices 212 bonded to the second temporary bonding layer 232 and the second temporary carrier layer 230.

Referring to Fig. 2h, the method further comprises exposing 114 at least parts 234 of the second temporary bonding layer 232 to second electromagnetic radiation 252 in order to reduce the binding strength of the exposed parts 234 of the second temporary bonding layer 232 with the array of integrated circuit devices 212.

During exposure, a source 250 of the second electromagnetic radiation 252 is arranged such that the second temporary bonding layer is located between the array of integrated circuit devices 212 and the source 250 of the second electromagnetic radiation 252. In some embodiments, this entails flipping the assembly of the array of integrated circuit devices 212 bonded to the second temporary bonding layer 232 and the second temporary carrier layer 230.

Exposing 114 at least parts 234 of the second temporary bonding layer 232 to second electromagnetic radiation 252 implies that the second temporary bonding layer 232 absorbs at least parts of the second electromagnetic radiation 252. Thus, energy from the absorbed second electromagnetic radiation 252 causes the material properties of the exposed parts 234 of the second temporary bonding layer 232 to change.

In some embodiments, exposing 114 at least parts 234 of the second temporary bonding layer 232 to second electromagnetic radiation 252 in order to reduce the binding strength of the exposed parts 234 of the second temporary bonding layer 232 may imply that the exposed parts 234 of second temporary bonding layer 232 is at least partially ablated and removed. Thus, the exposed parts 234 of second temporary bonding layer 232 may be at least partially detached from the array of integrated circuit devices 212 and the second temporary carrier layer 230. In other words, an effective area over which the second temporary bonding layer 232 bonds the array of integrated circuit devices 212 with the second temporary carrier layer 230 is reduced, such that the bonding strength of the array of integrated circuit devices 212 with second temporary bonding layer 232 and the second temporary carrier layer 230 is reduced.

The degree to which the material of the exposed parts of second temporary bonding layer are ablated may depend on properties of the second electromagnetic radiation such as power, wavelength, spot size, and position of the radiation as well as material properties of the material of the second temporary bonding layer.

Alternatively, in some embodiments exposing 114 does not imply that a material of the second temporary bonding layer 232 is removed or completely removed from the exposed parts 234. The material of the second temporary bonding layer 232 may remain between the array of integrated circuit devices 212 and the second temporary carrier layer 230 after exposure. It is to be understood that the binding strength of the exposed parts 234 is reduced due to the changed material properties of the material of the second temporary bonding layer 232 due to exposure to the second electromagnetic radiation 252. The material properties being changed upon exposure to the second electromagnetic radiation may be referred to as being less adhesive. Less adhesive may refer to the second temporary bonding layer 232 locally detaching, fully or partially, from the second temporary carrier layer 230 and from the integrated circuit devices 212.

Reducing the binding strength facilitates lifting of the integrated circuit devices 212 from the second temporary bonding layer 232 and the second temporary carrier layer 230.

The second electromagnetic radiation may be a second laser beam. Accordingly, the second electromagnetic radiation may be coherent radiation or formed in a coherent radiation source.

The second laser beam may be focused to a small spot size, and may have a narrow wavelength bandwidth around a second peak wavelength. The second laser beam may be tunable for controlling for example the spot size and/or the power of the laser beam.

The second laser beam may be controlled to expose the at least parts 234 of the second temporary bonding layer 232. Such controlling of the second laser beam may comprise controlling for example the spot size and/or the power of the laser beam in dependence of a position of the second laser beam.

The controlling of the second laser beam may further imply that the second laser beam is scanned in relation to the second temporary bonding layer 232. Thus, desired parts 234 of the second temporary bonding layer 232 may be exposed by a control of the second laser beam to direct the second laser beam towards the desired parts.

The control of the second laser beam may be such that the second laser beam is only directed to desired parts 234 of the second temporary bonding layer 232. Hence, during a scanning process, the second laser beam may be moved in steps such that a gap is provided between adjacent focus spots of the second laser beam, such that some parts 233 of the second temporary bonding layer 232 are unexposed.

The second temporary carrier layer 230 may be transparent to the second electromagnetic radiation 252. Thus, second electromagnetic radiation 252 may be transmitted through the second temporary carrier layer 230 before exposing the second temporary bonding layer 232.

The second temporary bonding layer may comprises divinylsiloxane-bis-benzocyclobutene, DVS-BCB. Also or alternatively, the second temporary bonding layer may comprise for example polyimide.

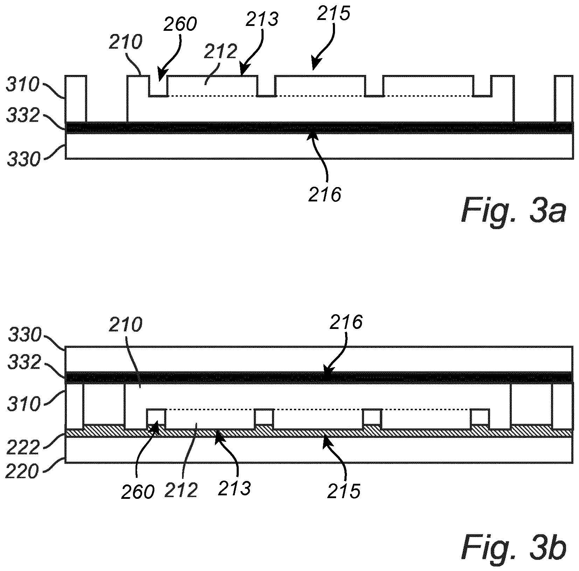

Referring to Fig. 3a, the method 100 may optionally comprise a step of, prior to bonding 103 the at least one device substrate 210 to the first temporary bonding layer 222 and the first temporary carrier layer 220, bonding 103b the at least one device substrate 210 to a preliminary bonding layer 332 and a preliminary carrier layer 330. The second side 216 of the at least one device substrate 210 may face the preliminary bonding layer 332 and the preliminary carrier layer 330.

The at least one device substrate 210 may be bonded to the preliminary bonding layer 332, and the preliminary bonding layer 332 may be bonded to both the at least one device substrate 210 and the preliminary carrier layer 330. In other words, the preliminary bonding layer 332 may be arranged between the preliminary carrier layer 330 and the at least one device substrate 210 and bind them together.

In some embodiments, one or more support structures 310 may be bonded to the preliminary bonding layer 332 and the preliminary carrier layer 330. The one or more support structures 310 may be arranged laterally to the at least one device substrate 210 comprising the array of integrated circuit devices 212. The support structures 310 may have a similar thickness as the at least one device substrate 210.

In embodiments where the at least one device substrate 210 comprises a plurality of device substrates, at least one of the one or more support structures 310 may be arranged between each device substrate.

The at least one device substrate 210 comprising the array of integrated circuit devices 212, and the one or more support structures 310, may be bonded, laterally side-by-side, to the preliminary bonding layer 332. In other words, the preliminary bonding layer 332 may be arranged between the preliminary carrier layer 330 and the support structures 310 and bind them together.

Referring to Fig. 3b, the bonding 103 the at least one device substrate 210 to the first temporary bonding layer 232 and the first temporary carrier layer 230 may be performed as previously described after the step of bonding 103b the at least one device substrate 210 to a preliminary bonding layer 332 and a preliminary carrier layer 330.

The method 100 may comprise, between the step of bonding 103 the at least one device substrate 210 to the first temporary bonding layer 232 and the first temporary carrier layer 230 and the step of thinning 104 the at least one device substrate 210, a step of debonding 104b the preliminary bonding layer 332 in order to modify material properties of a material of the preliminary bonding layer 332 to facilitate the removal of the material of the preliminary bonding layer 332.

The method 100 may further comprise, between the step of debonding 104b the preliminary bonding layer 332 and thinning 104 the at least one device substrate 210, a step of removing 104c the preliminary bonding layer 332 and the preliminary carrier layer 330.

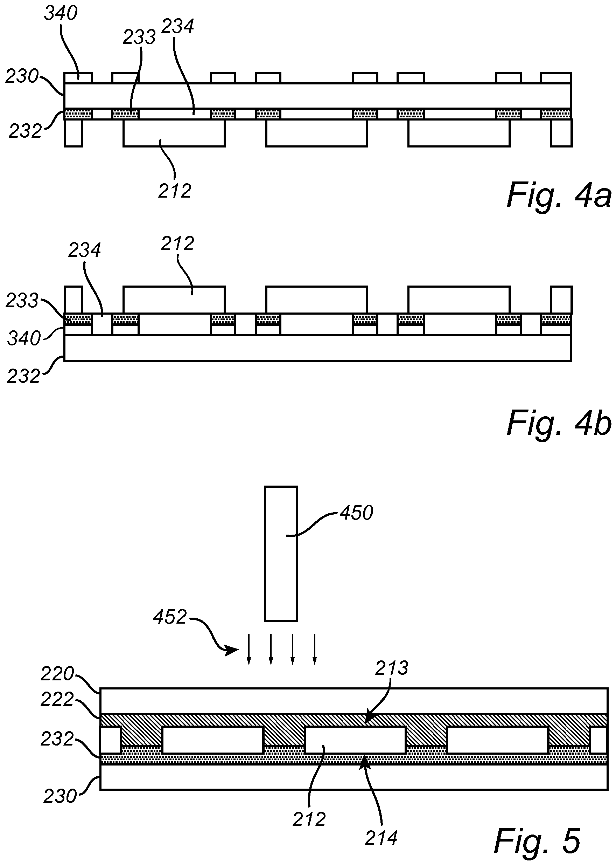

Referring to Fig. 4a and b, the method 100 may optionally comprise a step of depositing 113 a mask 340 on the second temporary carrier layer 230. The deposition 113 of the mask may be performed at any time prior to exposing 114 at least parts 234 of the second temporary bonding layer 232 to the second electromagnetic radiation 252. The mask 340 comprises a material that at least partially blocks the second electromagnetic radiation 252.

Alternatively, the second temporary carrier layer 230 may comprise a pre-fabricated mask 340. The pre-fabricated mask 340 comprises a material that at least partially blocks the second electromagnetic radiation 252.

The mask 340 or the pre-fabricated mask 340 is arranged between the second temporary carrier layer 230 and the source 250 of the second electromagnetic radiation 252 during exposing 114 of at least parts 234 of the second temporary bonding layer 232 to the second electromagnetic radiation 252. The mask 340 or the pre-fabricated mask 340 may be arranged on the second temporary carrier layer such that the mask 340 or the pre-fabricated mask 340 abuts either the carrier layer bottom surface (Fig. 4a) or the carrier layer top surface (fig. 4b).

The material that at least partially blocks the second electromagnetic radiation 252 may be patterned in the mask 340 or the pre-fabricated mask 340 in order to control which parts 234 of the second temporary bonding layer 232 are exposed. When the mask 340 or the pre-fabricated mask 340 is exposed to second electromagnetic radiation 252, the portion of the second electromagnetic radiation 252 that is transmitted through the mask 340 or the pre-fabricated mask 340 is at least partially reduced in regions of the mask 340 or the pre-fabricated mask 340 that are patterned with the material that at least partially blocks the second electromagnetic radiation 252. The mask 340 or the pre-fabricated mask 340 may also be referred to as a photomask or a reticle. The mask 340 or the pre-fabricated mask 340 may be a hard mask.

Referring to Fig. 5, debonding 110 the first temporary bonding layer 222 may optionally comprise exposing 110b the first temporary bonding layer 222 to the first electromagnetic radiation 452.

The first electromagnetic radiation 452 may be formed in a source 450 of the first electromagnetic radiation 452. The source 450 of the first electromagnetic radiation 452 and the source 250 of the second electromagnetic radiation 252 may be the same, common, source of electromagnetic radiation.

The first electromagnetic radiation 452 may be a first laser beam.

The first laser beam may be focused to a small spot size, and may have a narrow wavelength bandwidth around a first peak wavelength. The first laser beam may be tunable for controlling for example the spot size and/or the power of the laser beam.

The first laser beam and the second laser beam may be formed by the same source. The laser may be an excimer laser or an exciplex laser.

The exposing 110b of the first temporary bonding 222 layer to the first electromagnetic radiation 452 may comprise scanning the first temporary bonding layer 222 with the first laser beam.

Scanning may refer to moving the first laser beam over the first temporary bonding layer 222 in a number of consecutive steps. The scanning may involve moving the first laser beam uniformly over the first temporary bonding layer 222, that is with a spot of the laser beam being moved an equal distance between consecutive steps. The beam spots of consecutive steps may have a small overlap, no overlap or a small gap in-between the beam spots.

The power and the spot size of the first laser beam may be constant during the scanning. Thus, the exposure of the first temporary bonding layer 222 to the first electromagnetic radiation 452 may be controlled for example by controlling the speed of the scan and parameters of the first laser beam, such as the power and spot size.

The first temporary carrier layer 220 may be transparent to the first electromagnetic radiation 452. Thus, first electromagnetic radiation 452 may be transmitted through the first temporary carrier layer 220 before exposing the first temporary bonding layer 222.

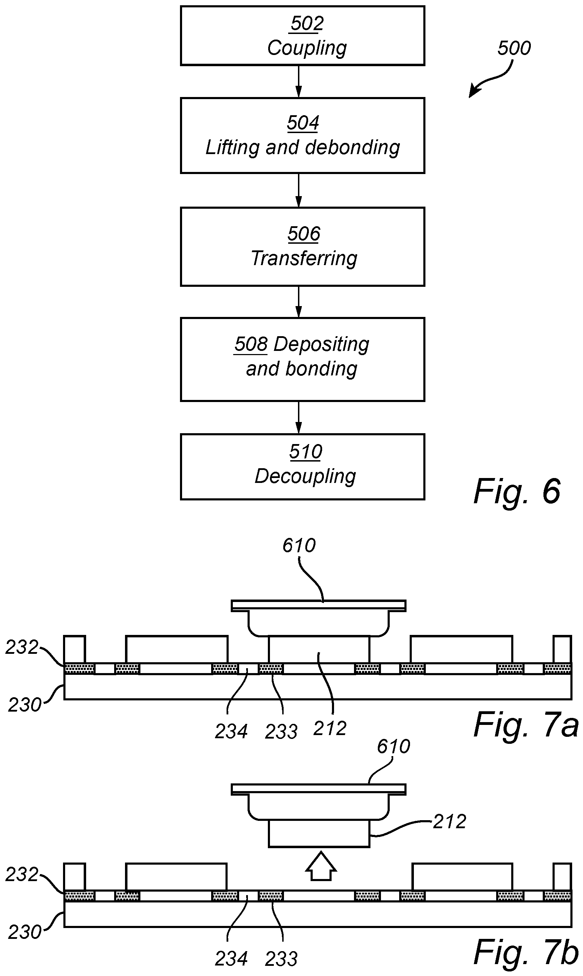

Referring to Fig. 6 in conjunction with Figs 7a-7e, a method 500 for transfer printing will be described. The method for transfer printing comprises at least the steps 110, 112, and 114 of the method 100 for preparing an array of integrated circuit devices 212 for transfer printing. The method 500 for transfer printing may optionally comprise any other of the steps previously described in the method 100 for preparing an array of integrated circuit devices 212 for transfer printing.

Referring to Fig. 7a, the method 500 for transfer printing may comprise releasably coupling 502 at least one integrated circuit device 212 of the array of integrated circuit devices 212 to a stamp 610. The stamp 610 is configured to facilitate coupling and decoupling between the stamp 610 and the at least one integrated circuit device 212. Coupling and decoupling of the stamp 610 may be mechanical employing for example Van der Waals forces, mechanical peeling and rate-dependent adhesion. Referring to Fig. 7b, the method 500 for transfer printing may comprise lifting 504 the coupled at least one integrated circuit device 212 from the second temporary bonding layer 232 and the second temporary carrier layer 230. In other words, the at least one integrated circuit device 212 is released from the second temporary bonding layer 232 and the second temporary carrier layer 230 as a result of being lifted by the stamp 610.

Thanks to the integrated circuit devices 212 being attached to the second temporary carrier layer 230 by a reduced binding strength of the second temporary bonding layer 232, the lifting of the at least one integrated circuit device 212 from the second temporary bonding layer 232 and the second temporary carrier layer 230 may require a very small force. The force required need only overcome the binding strength of the second temporary bonding layer 232 which may only be present in a fraction of an area of the second temporary bonding layer 232.

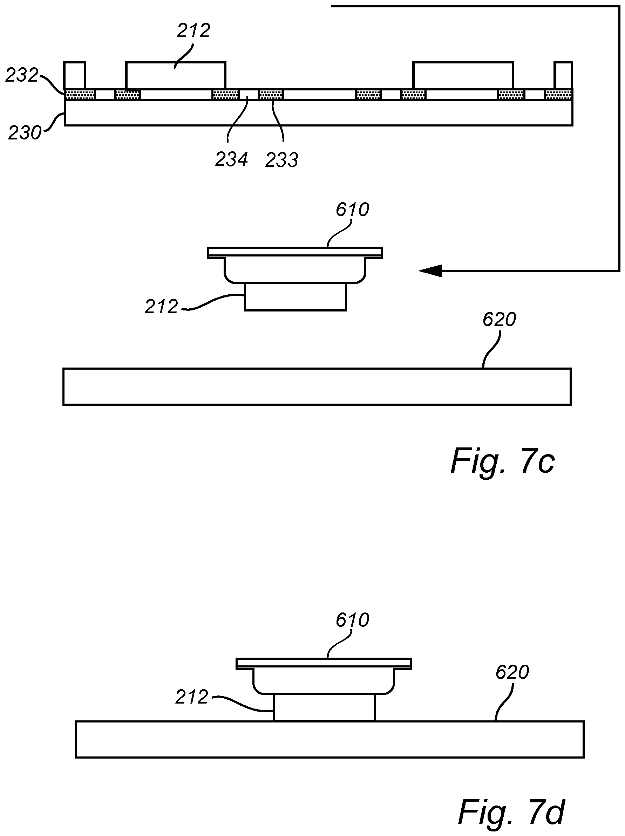

Referring to Fig. 7c, the method 500 for transfer printing may comprise transferring 506 the at least one integrated circuit device 212 to a target substrate 620. The target substrate 620 may include one or more integrated circuits such that the device being transferred to the target substrate may be coupled to the integrated circuit(s) on the target substrate 620.

Referring to Fig. 7d, the method 500 for transfer printing may comprise depositing and bonding 508 the transferred at least one integrated circuit device 212 to the target substrate 620.

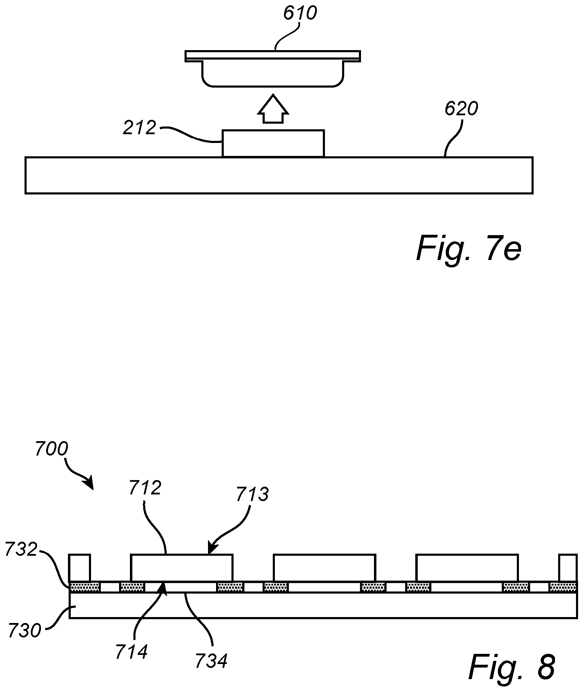

Referring to Fig. 7e, the method 500 for transfer printing may comprise decoupling 510 the stamp 610 from the transferred and bonded at least one integrated circuit device 212. Decoupling may be facilitated by a binding strength between the target substrate 620 and the transferred and bonded at least one integrated circuit device 212 that is stronger than a coupling strength between the stamp 610 and the at least one integrated circuit device 212.

Referring to Fig. 8, an assembly 700 of integrated circuit devices 712 for transfer printing is described. The assembly 700 may correspond to the assembly of the array of integrated circuit devices 212 bonded to the second temporary bonding layer 232 and the second temporary carrier layer 230 shown in Fig. 2h above after the exposure to the second electromagnetic radiation.

The assembly 700 comprises a temporary carrier layer 730 and a temporary bonding layer 732 arranged on one side of the temporary carrier layer 730.

An array of integrated circuit devices 712 is arranged on the temporary bonding layer 732. The array of integrated circuit devices 712 comprises a first side 713 and a second side 714, wherein the array of integrated circuit devices 712 is arranged on the temporary bonding layer 732 with the second side 714 facing the temporary bonding layer 732.

At least parts of the temporary bonding layer 732 have a reduced binding strength with the array of integrated circuit devices 712 in order to facilitate lifting of the integrated circuit devices 712 from the second temporary bonding layer 732 and the temporary carrier layer 730.

The reduced binding strength of the temporary bonding layer 732 with the array of integrated circuit devices 712 may be achieved according to the previously described method 100 for preparing an array of integrated circuit devices 212 for transfer printing.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method (100) for preparing an array of integrated circuit devices (212) for transfer printing, said method comprising:
debonding (110) a first temporary bonding layer (222) by modifying material properties of a material of the first temporary bonding layer (222) to facilitate the removal of the material of the first temporary bonding layer (222); wherein
the first temporary bonding layer (222) is arranged between a first temporary carrier layer (220) and the array of integrated circuit devices (212), for binding the array of integrated circuit devices (212) to the first temporary carrier layer (220), wherein the first temporary bonding layer (222) covers at least a first side (213) of the array of integrated circuit devices (212);
a second temporary bonding layer (232) covers at least a second side (214) of the array of integrated circuit devices (212), wherein the second side (214) is opposite to the first side (213); and
the second temporary bonding layer (232) is arranged between a second temporary carrier layer (230) and the array of integrated circuit devices (212), for binding the array of integrated circuit devices (212) to the second temporary carrier layer (230);
removing (112) the first temporary bonding layer (222) and the first temporary carrier layer (220);
exposing (114) at least parts (234) of the second temporary bonding layer (232) to second electromagnetic radiation (252) in order to reduce a binding strength of the exposed parts (234) of the second temporary bonding layer (232) with the array of integrated circuit devices (212);
wherein reducing the binding strength facilitates lifting of integrated circuit devices (12) of the array of integrated circuit devices (212) from the second temporary bonding layer (232) and the second temporary carrier layer (230).

2. The method according to claim 1, wherein the second electromagnetic radiation (252) is a second laser beam.

3. The method according to claim 2, wherein the exposing (114) of at least parts (234) of the second temporary bonding layer (232) to the second electromagnetic radiation (252) comprises controlling the second laser beam to expose at least parts (234) of the second temporary bonding layer (232).

4. The method according to any of the previous claims, wherein the debonding (110) the first temporary bonding layer (222) comprises exposing (110b) the first temporary bonding layer (222) to first electromagnetic radiation (452).

5. The method according to claim 4, wherein the first electromagnetic radiation (452) is a first laser beam.

6. The method according to claim 5, wherein the exposing (110) of the first temporary bonding layer (222) to the first electromagnetic radiation (452) comprises scanning the first temporary bonding layer (222) with the first laser beam.

7. The method according to any one of the previous claims, further comprising depositing (113) a mask (340) on the second temporary carrier layer (230), wherein
the deposition (113) of the mask (340) is performed before the exposing (114) of at least parts (234) of the second temporary bonding layer (232) to the second electromagnetic radiation (252); and
the mask (340) comprises a material that at least partially blocks the second electromagnetic radiation (252).

8. The method according to any one of claims 4 to 7, wherein the first temporary carrier layer (220) is transparent to the first electromagnetic radiation, and the second temporary carrier layer (230) is transparent to the second electromagnetic radiation.

9. The method according to any one of the previous claims, wherein the second temporary bonding layer comprises divinylsiloxane-bis-benzocyclobutene, DVS-BCB.

10. The method according to any one of the previous claims, further comprising:
selectively removing (102) material from a first side (215) of at least one device substrate (210), wherein the at least one device substrate (210) comprises the array of integrated devices and wherein the first side (215) of the at least one device substrate (210) faces a same direction as the first side (213) of the array of integrated circuit devices (212), wherein the selective removing (102) of material forms a plurality of channel portions (260) in the at least one device substrate (210), wherein each integrated circuit device (12) of the array of integrated circuit devices (212) is individually surrounded by one or more channel portions (260).

11. The method according to claim 10, further comprising:
bonding (103) the at least one device substrate (210) comprising the array of integrated circuit devices to the first temporary bonding layer (222) and the first temporary carrier layer (220), wherein the first side (215) of the at least one device substrate (210) faces the first temporary bonding layer (222) and the first temporary carrier layer (220);

12. The method according to claim 11, further comprising:
thinning (104) the at least one device substrate (210) by removing material of the at least one device substrate (210) from a second side (216) of the at least one device substrate (210) opposite to the first side (215), wherein said thinning is performed at least until reaching a bottom (264) of the plurality of channel portions (260) surrounding each integrated circuit device.

13. The method according to any one of the previous claims, further comprising:
bonding (105) the array of integrated circuit devices (212) to the second temporary bonding layer (232) and the second temporary carrier layer (230), wherein the second side (214) of the array of integrated circuit devices faces the second temporary bonding layer (232) and the second temporary carrier layer (230).

14. A method for transfer printing, said method comprising:
the method for preparing the array of integrated circuit devices for transfer printing according to any one of the previous claims, and
transferring (506) at least one integrated circuit device (12) from the array of integrated circuit devices (212) to a target substrate (620)by lifting the at least one integrated circuit device (12) from the second temporary bonding layer (232) and the second temporary carrier layer (230) and depositing it on the target substrate.

15. An assembly of integrated circuit devices (712) for transfer printing, the assembly comprising:
a temporary carrier layer (730);
a temporary bonding layer (732) arranged on one side of the temporary carrier layer (730);
an array of integrated circuit devices (712) comprising a first side (713) and a second side (714), wherein the array of integrated circuit devices (712) is arranged on the temporary bonding layer (732) with the second side (714) facing the temporary bonding layer (732);
wherein parts (234) of the temporary bonding layer has a reduced binding strength with the array of integrated circuit devices (712) in order to facilitate lifting of the integrated circuit devices (712) from the temporary bonding layer (732) and the temporary carrier layer (730).
